# EUROPEAN PATENT APPLICATION

(11) **EP 3 147 953 A1**
(43) Date of publication of application: **29.03.2017**
(21) Application number: 16190777.9
(22) Date of filing: 27.09.2016
(51) Int. Cl.: H01L 31/05, H01L 31/0465, H02S 40/36

(54) **SOLAR CELL MODULE**

(30) Priority: 28.09.2015 JP 2015190404
(71) Applicant: Panasonic Intellectual Property Management Co., Ltd., Osaka-shi, Osaka 540-6207 (JP)
(72) Inventor: MURAKAMI, Youhei, Osaka, Osaka 540-6207 (JP); MAEKAWA, Akimichi, Osaka, Osaka 540-6207 (JP)
(74) Representative: Appelt, Christian W.

(57) **Abstract**

The serial resistance of a solar cell module is reduced while shadow loss is being suppressed. A solar cell module 10, which is an example of the embodiments, includes a first protection member 12 being disposed on the light receiving surface side of the solar cell module and having transparency, a second protection member 13 disposed on the rear surface side, and a string 19 provided between the first protection member 12 and the second protection member 13. The string 19 includes a plurality of solar cells 11 each having a plurality of finger electrodes 25, formed so as to be approximately parallel to each other on the rear surface of a photoelectric conversion part 20, a plurality of wiring members 15 fitted to each of the solar cells 11, in a direction intersecting a plurality of finger electrodes 25 and connecting the adjacent solar cells 11 to each other, and the metal foils 17 provided, on the rear surface side of the photoelectric conversion part 20, at the overlapping the wiring members 15, at intervals from each other, in a direction intersecting the plurality of finger electrodes 25, and electrically connecting the plurality of the finger electrodes 25 and the wiring members 15.

## Description

### CROSS REFERENCE TO RELATED APPLICATION

The entire disclosure of Japanese Patent Application No. 2015-190404 filed on September 28, 2015, including specification, claims, drawings and abstract, is incorporated herein by reference in its entirety.

### TECHNICAL FIELD

The present disclosure relates to a solar cell module.

### BACKGROUND

There has hitherto been proposed a solar cell module provided with metal foils covering, over wiring members, the collector electrodes formed on the rear surfaces of photoelectric conversion parts (see Patent Literature 1). Patent Literature 1 describes reduction of the serial resistance in modularization through the same effect achieved by the provision of the metal foils as the effect due to increase in the thickness of the wiring members. In Patent Literature 1, the dimensions of the metal foils are described to be preferably the larger the better; Patent Literature 1 discloses a structure provided with metal foils so as to cover almost the whole area of the rear surfaces of the photoelectric conversion parts.

### CITATION LIST

### PATENT LITERATURE

Patent Literature 1: JP 2005-167158 A

### SUMMARY

### TECHNICAL PROBLEM

However, as in the solar cell module disclosed in Patent Literature 1, when metal foils are provided on almost the whole area of the rear surfaces of the photoelectric conversion parts, light is not incident from the rear surface side of the cells, for example, in such a way that the light incident from the rear surface side of the solar cell module cannot be utilized for power generation. Even when the light incident from the light receiving surface side of the solar cell module is reflected by a back sheet or the like, the metal foils shield the reflected light and hence the reflected light is not incident on the rear surface side of the cells. In other words, it is an important technical problem to reduce the serial resistance of the solar cell module while shadow loss is being suppressed.

### SOLUTION TO PROBLEM

The solar cell module as an aspect of the present disclosure includes a first protection member, having transparency, disposed on the light receiving surface side of the solar cell module, a second protection member disposed on the rear surface side of the solar cell module, and a string disposed between the first protection member and the second protection member, wherein the string includes a plurality of solar cells respectively having a plurality of finger electrodes formed on the rear surface of a photoelectric conversion part so as to be approximately parallel to each other, a plurality of wiring members fitted respectively to the solar cells in directions intersecting the plurality of finger electrodes and connecting the adjacent solar cells to each other, and a plurality of metal foils provided at intervals from each other on the rear surface side of the photoelectric conversion part, at positions overlapping the wiring members in the directions intersecting the plurality of finger electrodes and electrically connecting the plurality of finger electrodes and the wiring members.

### ADVANTAGEOUS EFFECTS OF INVENTION

According to an aspect of the present disclosure, it is possible to provide a solar cell module having a high efficiency of light utilization and a low serial resistance.

### BRIEF DESCRIPTION OF DRAWINGS

Embodiments of the present invention will be described based on the following figures, wherein:
FIG. 1 is a cross-sectional view of a solar cell module as an example of embodiments;
FIG. 2 is a plan view of a solar cell with metal foils as an example of the embodiments, as viewed from the rear surface side;
FIG. 3 is a cross-sectional view along the AA line in FIG. 2;
FIG. 4 is a diagram illustrating the state of fitting wiring members to the solar cell with metal foils, as an example of the embodiments;
FIG. 5 is a cross-sectional view along the BB line in FIG. 4;
FIG. 6 is a diagram illustrating a metal foil as another example of the embodiments;
FIG. 7 is a diagram illustrating metal foils as another example of the embodiments;
FIG. 8 is a diagram illustrating a metal foil as another example of the embodiments; and
FIG. 9 is a diagram illustrating the formation pattern of collector electrodes as another example of the embodiments.

### DESCRIPTION OF EMBODIMENTS

Hereinafter, an example of the embodiments will be described in detail.

The drawings referred to in the description of the embodiments are schematically drawn, and the dimensional proportions or the like of the constituent elements depicted in the drawings are sometimes different from those of the actual constituent elements or the like. Specific dimensional proportions or the like should be determined in consideration of the following descriptions. In the present description, the term "approximately **" is intended to mean, for example, in the case of "approximately the same," of course the case of being exactly the same and also the case of being regarded as substantially the same. Additionally, the term "edge" means the edge of an object and the vicinity thereof.

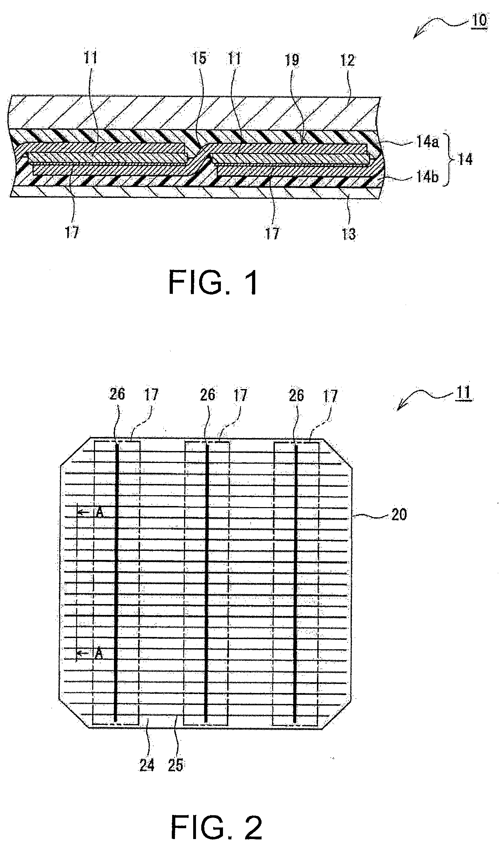

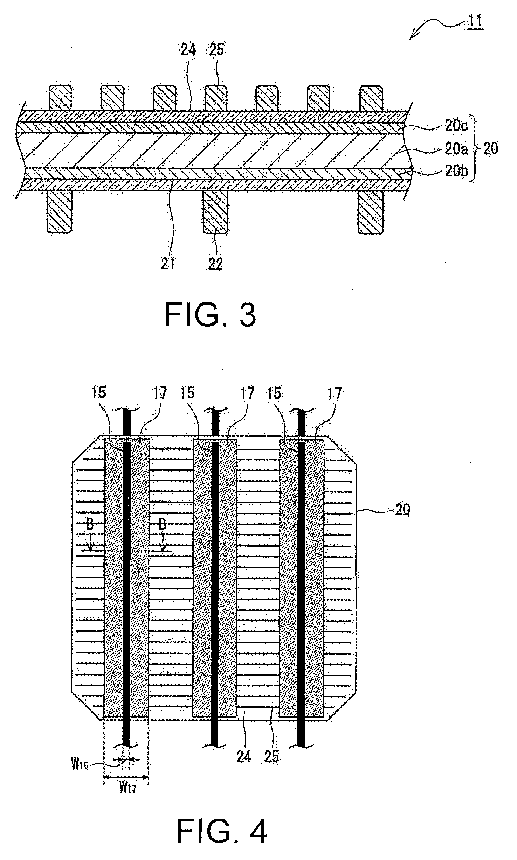

Hereinafter, with reference to FIG. 1 to FIG. 5, a solar cell module 10, an example of the embodiments, is described in detail. FIG. 1 is a cross-sectional view of the solar cell module 10. FIG. 2 is a plan view of a solar cell 11 with metal foils 17 joined thereto, as viewed from the rear surface side, and FIG. 3 is a cross-sectional view along the AA line in FIG. 2. In FIG. 2, the metal foils 17 are shown with imaginary lines (two-dot chain line) in order to show the current collecting electrodes hidden by the metal foils 17.

As shown in FIG. 1, the solar cell module 10 includes a plurality of solar cells 11 each having collector electrodes (not shown in FIG. 1), and a plurality of wiring members 15 connecting the adjacent solar cells 11 to each other. The solar cell module 10 also includes a plurality of metal foils 17 provided at intervals from each other on the rear surface side of the solar cells 11, at positions overlapping the wiring members 15, and electrically connecting the collector electrodes and the wiring members 15. As detailed later, the metal foils 17 are generally lower in resistance (higher in conductivity) than the collector electrodes, and hence the formation of low resistance conductive paths through the intermediary of the metal foils 17 can reduce the serial resistance of the module.

In the example shown in FIG. 1, a metal foil 17 is provided between the rear surface of each of the solar cells 11 and the wiring member 15. When the metal foil 17 is provided between the rear surface of the solar cell 11 and the wiring member 15, the metal foil 17 can be said to be a constituent element of the solar cell 11. In the present description, the solar cell 11 provided with the metal foils 17 is sometimes referred to as the solar cell 11 with metal foils. The metal foils 17 are not provided on the light receiving surface side of the solar cell 11, but are provided only on the rear surface side of the solar cell 11, in consideration of shadow loss. In the present description, the "light receiving surface" of each of the photoelectric conversion part, the solar cell and the solar cell module means the surface on which sunlight is mainly incident (exceeding 50%), and the "rear surface" means the surface opposite to the light receiving surface.

The solar cell module 10 includes a first protection member 12 provided on the light receiving surface side of the solar cells 11, a second protection member 13 provided on the rear surface side of the solar cells 11, and a sealing material 14 filled between the protection members. The plurality of the solar cells 11 are sealed with the sealing material 14 between the first protection member 12 and the second protection member 13. The sealing material 14 includes, for example, a first sealing material 14a provided between the solar cells 11 and the first protection member 12, and a second sealing material 14b provided between the solar cells 11 and the second protection member 13. The solar cell module 10 is generally produced by laminating the thin plate-like or film-like constituent members.

For the first protection member 12, a member having transparency such as a glass substrate, a resin substrate, or a resin sheet can be used. Among these, from the viewpoint of fire resistance, durability or the like, it is preferable to use a glass substrate. For the second protection member 13, the same transparent member as the first protection member 12 or an opaque member may be used. For example, a glass substrate is used for the first protection member 12, and a resin film is used for the second protection member 13. For the sealing material 14, for example, an olefin resin or a copolymer between α-olefin and a carboxylic acid vinyl ester such as ethylene-vinyl acetate copolymer (EVA) is used.

The solar cell module 10 has a string 19 formed by connecting the adjacent solar cells 11 to each other with wiring members 15. The string 19 is a unit formed of a plurality of solar cells 11 arranged so as to form a line and electrically connected to each other with wiring members 1. In the present embodiment, the plurality of solar cells 11 are serially connected to each other with the wiring members 15. The wiring members 15 are bent between the adjacent solar cells 11 in the thickness direction of the solar cell module 10, in such a way that the wiring members are fitted to the light receiving surface of one of the adjacent solar cells 11 and the rear surface of the other of the adjacent solar cells 11. A plurality of the wiring members 15 are fitted to each of the solar cells 11 (see FIG. 4 presented below). In the present embodiment, the adjacent solar cells 11 are connected to each other with the three wiring members 15.

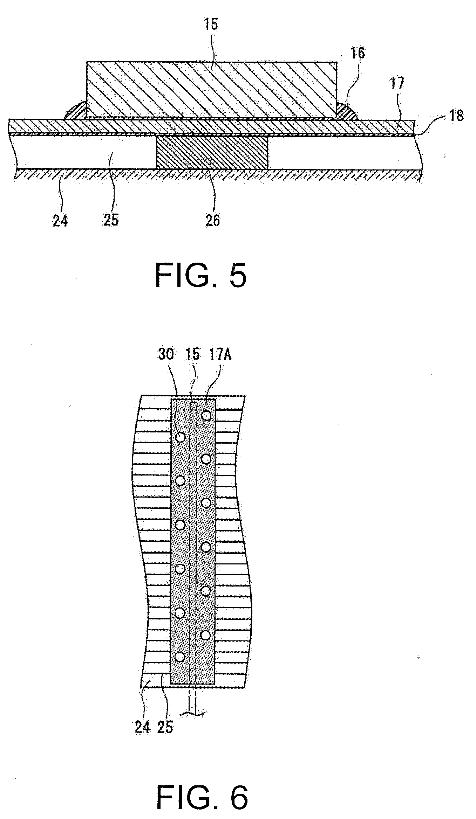

The wiring member 15 is a belt-like conductive metal wire constituted by a metal such as copper, aluminum, silver, or an alloy including at least one of these metals. For example, the width of the wiring member 15 is 10 mm to 30 mm, and the thickness of the wiring member 15 is 20 µm to 40 µm. The wiring member 15 may be fitted to the light receiving surface and the rear surface of the solar cell 11 with solder, and is preferably fitted with an adhesive 16 (see FIG. 5 presented below). The adhesive 16 may be either a conductive adhesive including conductive particles or an insulating adhesive constituted only with a resin component. However, at least the adhesive applied to the light receiving surface is preferably a transparent insulating adhesive. Examples of the conductive particles may include metal particles such as silver particles, copper particles and nickel particles, carbon particles, and mixtures of these particles. Preferable among these are silver particles.

As shown in FIG. 2 and FIG. 3, the solar cell 11 has a photoelectric conversion part 20 to produce carriers by receiving sunlight, and pluralities of collector electrodes formed respectively on the light receiving surface and the rear surface of the photoelectric conversion part 20. The shape of the photoelectric conversion part 20 is not particularly limited, and in the example shown in FIG. 2, the photoelectric conversion part 20 has an octagonal shape. In other words, the photoelectric conversion part 20 has an approximately square shape in plan view with oblique sides at four corners. The collector electrodes are each a fine wire-shaped electrode to collect the carriers generated in the photoelectric conversion part 20, and are preferably formed on a wide range on each of the light receiving surface and the rear surface. The carriers collected by the collector electrodes are taken out to the outside through the wiring members 15.

The photoelectric conversion part 20 preferably has a semiconductor substrate 20a, and amorphous semiconductor layers 20b and 20c formed on the substrate. Examples of the semiconductor substrate 20a may include semiconductor wafers made of crystalline silicon (c-Si), gallium arsenide (GaAs) and indium phosphide (InP). The crystalline silicon wafer is preferable among these, and an n-type single crystalline silicon wafer is particularly preferable. As an example of a preferable photoelectric conversion part 20, there may be quoted a photoelectric conversion part having a structure in which on the light receiving surface of an n-type single crystalline silicon wafer, an i-type amorphous silicon layer and a p-type amorphous silicon layer are sequentially formed, and on the rear surface, an i-type amorphous silicon layer and an n-type amorphous silicon layer are sequentially formed.

The photoelectric conversion part 20 preferably has transparent conductive layers 21 and 24 respectively formed on the amorphous semiconductor layers 20b and 20c. The transparent conductive layers 21 and 24 are each constituted with a transparent conductive oxide formed by doping, for example, tin (Sn) or antimony (Sb) in a metal oxide such as indium oxide (In₂O₃) or zinc oxide (ZnO). The transparent conductive layers 21 and 24 are preferably formed on the light receiving surface and the rear surface of the photoelectric conversion part 20, respectively in such a way that the transparent conductive layers are each formed on almost the whole area of the surface involved except for the edges of the surface involved.

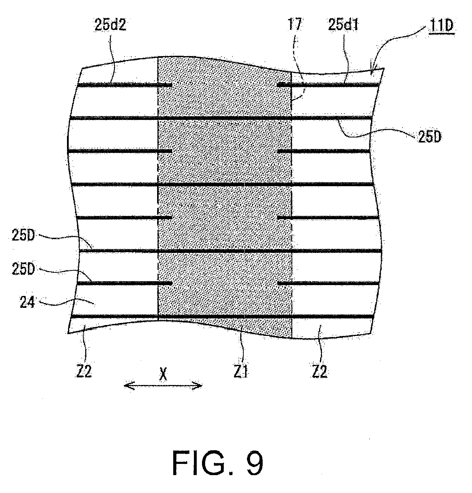

In the present embodiment, on the light receiving surface of the photoelectric conversion part 20, as collector electrodes, a plurality of finger electrodes 22 and a plurality of bus bar electrodes (not shown) are formed. On the rear surface of the photoelectric conversion part 20, a plurality of finger electrodes 25 and a plurality of bus bar electrodes 26 are formed respectively as the collector electrodes. The pluralities of the finger electrodes 22 and 25 are formed respectively in the wide ranges on the transparent conductive layers 21 and 24. In each of the pluralities of the finger electrodes, the finger electrodes all extend in the same direction, and are formed so as to be approximately parallel to each other at approximately equal intervals from each other. Each of the plurality of the bus bar electrodes 26 is formed in a state of being approximately perpendicular to each of the finger electrodes 25 (this is also the case for the bus bar electrodes on the light receiving surface side). In the example shown in FIG. 2, three bus bar electrodes 26 are formed so as to be approximately parallel to each other at approximately equal intervals from each other. The collector electrodes may have a constitution free from bus bar electrodes (for example, see FIG. 9 presented below).

The finger electrodes 25 are preferably formed in larger areas than the finger electrodes 22. For example, the finger electrodes 25 are formed wider in width than the finger electrodes 22, and additionally, larger in number than the finger electrodes 22. In order to enhance the current collectability while the shadow loss is being suppressed, the finger electrodes 22 are formed thicker than the finger electrodes 25. The finger electrodes 25 and the bus bar electrodes 26 both have approximately the same thickness. The finger electrodes 22 and the bus bar electrodes (not shown) on the light receiving surface side have also approximately the same thickness.

The thickness of the finger electrodes 25 and the thickness of the bus bar electrodes 26 are thinner than the thickness of the wiring members 15. The width of the bus bar electrodes 26 is preferably smaller than the width of the wiring members 15. The wiring members 15 are disposed in the lengthwise direction of the bus bar electrodes 26, above the bus bar electrodes 26 (see FIG. 5 presented below). The wiring members 15 are fitted to the rear surface of the solar cells 11, in a state of covering the whole of the bus bar electrodes 26.

The collector electrodes each have, for example, a structure in which the conductive particles are dispersed in a binder resin, and can be formed by printing a conductive paste on the photoelectric conversion part 20. For example, when the conductive particles are silver particles, a preferable content of the conductive particles is 60% by mass to 90% by mass in relation to the total weight of the collector electrodes. Examples of the binder resin may include thermosetting resins such as an epoxy resin, a urethane resin, a urea resin, an acrylic resin, an imide resin and a phenolic resin. The collector electrodes can be formed by a plating method, but are preferably formed by a printing method using a conductive paste from the viewpoint of productivity.

As described above, the solar cell module 10 includes the first protection member 12 having transparency, disposed on the light receiving surface side, the second protection member 13 disposed on the rear surface side, and the string 19 provided between the first protection member 12 and the second protection member 13. The string 19 includes a plurality of the solar cells 11 each having a plurality of finger electrodes 25 formed so as to be approximately parallel to each other on the rear surface of the photoelectric conversion part 20, a plurality of the wiring members 15, and a plurality of the metal foils 17. The wiring members 15 are fitted to each of the solar cells 11 in the direction intersecting the plurality of the finger electrodes 25 and connect the adjacent solar cells 11 to each other. The metal foils 17 are provided on the rear surface side of the photoelectric conversion part 20, at intervals from each other, at positions overlapping the wiring members 15 and in a direction intersecting the plurality of the finger electrodes 25, and electrically connect the plurality of the finger electrodes 25 and the wiring members 15.

Hereinafter, with reference to FIG. 4 and FIG. 5, the metal foils 17 and the structure related thereto are described in detail. FIG. 4 is a diagram illustrating the state of fitting the wiring members 15 to the solar cell 11 with metal foils. FIG. 5 is a cross-sectional view along the BB line in FIG. 4.

As shown in FIG. 4 and FIG. 5, the metal foils 17 are metal thin films electrically connecting the collector electrodes formed on the rear surface of the photoelectric conversion part 20 and the wiring members 15, and a plurality of the metal foils 17 are provided at intervals from each other in a state of overlapping the wiring members 15. In the part of the collector electrodes, in the proximity of the wiring members 15 (the part overlapping the wiring members 15), the current of the finger electrodes 25 is concentrated and the current density becomes high, and hence by increasing the current paths between the collector electrodes and the wiring members 15 through the intermediary of the metal foils 17, by providing the metal foils 17, the serial resistance of the string 19 can be reduced. The increase of the current paths due to the metal foils 17 decreases the electrical resistance between the whole of the collector electrodes and the wiring members 15.

The metal foils 17 may be provided in a state of covering the wiring members 15. Also, in this case, part of the metal foils 17 are disposed on the collector electrodes, and the electrical connection between the collector electrodes and the wiring members 15 through the intermediary of the metal foils 17 is formed. However, the thickness of the wiring members 15 is thicker than the thickness of the collector electrodes, and hence when the metal foils 17 are disposed on the wiring members 15, large cavities (air bubbles) tend to be present between the rear surface of the photoelectric conversion part 20 and the metal foils 17. When cavities are present, for example, exterior appearance faults such as the expansion of the second protection member 13 or the detachment of the sealing material 14 are sometimes caused in the laminating step or the subsequent curing step. Additionally, when the metal foils 17 are disposed on the wiring members 15, pressure is applied to the wiring members 15 and the solar cells 11 are sometimes damaged.

Accordingly, the metal foils 17 are preferably provided between the rear surface side of the photoelectric conversion part 20 and the wiring members 15. In the present embodiment, the metal foils 17 are provided in a state of being sandwiched by the finger electrodes 25 and the bus bar electrodes 26, the collector electrodes formed on the transparent conductive layer 24 constituting the rear surface of the photoelectric conversion part 20 and the wiring members 15. The metal foils 17 reliably intervene between the collector electrodes formed on the transparent conductive layer 24 and the wiring members 15, and the collector electrodes and the wiring members 15 are not brought into direct contact with each other. The metal foils 17 are preferably provided so as not to extend outside the rear surface of the photoelectric conversion part 20, in consideration of the prevention of the short-circuiting between the light receiving surface and the rear surface of the solar cell 11.

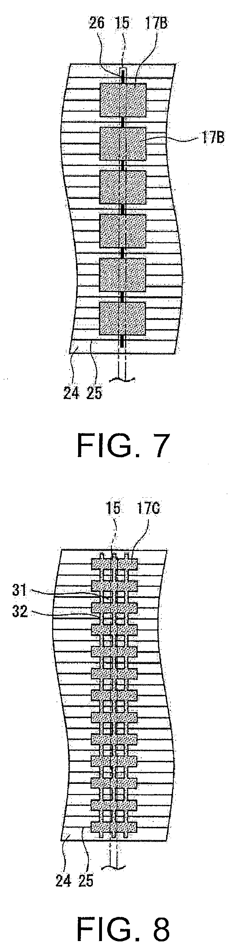

The metal foils 17 are formed, for example, in a belt-like form, and are provided in a state of being approximately perpendicular to the finger electrodes 25 in the lengthwise direction of the wiring members 15. The metal foils 17 are wider in width than the bus bar electrodes 26, and are longer in length than the bus bar electrodes 26 (see FIG. 2). The metal foils 17 have a long and narrow, approximately rectangular shape having an approximately constant width W₁₇, but the shape of the metal foil is not limited to this (see, for example, FIGS. 7 and 8 presented below). The metal foils 17 may have approximately the same shapes and the same dimensions as each other, or alternatively different shapes and different dimensions from each other.

In the present embodiment, the same number of the metal foils 17 as the number of the wiring members 15 fitted to the rear surface of the solar cell 11 are provided. On the rear surface side of the solar cell 11, three wiring members 15 are fitted, and three metal foils 17 are provided at the positions overlapping the wiring members 15. The metal foils 17 are disposed at intervals from each other, and on the rear surface of the solar cell 11, the rear surface (transparent conductive layer 24) of the photoelectric conversion part 20 is exposed between the collector electrodes in the region free from the metal foils 17. Thus, light can be incident from the rear surface side of the solar cell 11, and the serial resistance of the solar cell module can be reduced while the shadow loss is being suppressed.

The metal foils 17 are preferably provided on almost the whole area of the region (hereinafter, sometimes referred to as the "overlapping region") covered with the wiring members 15, on the rear surface of the solar cell 11. Moreover, it is preferable that the width W₁₇ of the metal foils 17 (the length in the widthwise direction of the wiring members 15) is longer than the width W₁₅ of the wiring members 15, and the metal foils 17 are provided in a state in which the metal foils 17 protrude outside the overlapping region of the wiring members 15, from both widthwise ends of the wiring members 15. The wiring members 15 are fitted to the widthwise central parts of the metal foils 17,.

The provision of the metal foils 17 so as to protrude from the overlapping region of the wiring members 15 leads to shadow loss, but the provision of the metal foils 17 in this portion is effective for the reduction of the serial resistance because in the part of the finger electrodes 25, in the proximity of the wiring members 15, the current of the finger electrodes 25 is concentrated and the current density is high. In the present embodiment, the metal foils 17 are provided in a state of covering the whole of the bus bar electrodes 26 and part of all the finger electrodes 25 connected to the bus bar electrodes.

The width W₁₇ of the metal foil 17 is, for example, 10 mm to 20 mm. The width W₁₇ of the metal foils 17 is preferably 1.5 to 10 times and more preferably 2 to 7 times the width W₁₅ of the wiring members 15. When the ratio of the width W₁₇ of the metal foils 17 to the width W₁₅ of the wiring members 15 is made to fall within the aforementioned range, the shadow loss and the reduction of the serial resistance can be made more efficiently compatible with each other. Between the metal foils 17, for example, an interval approximately corresponding to the width of one metal foil 17 is provided.

The metal foils 17 are metal thin films constituted by, for example, aluminum, copper, silver or nickel, or alloys mainly composed of these metals. In consideration of the material cost and conductivity, it is preferable to use metal foils 17 made of aluminum or an aluminum alloy. The thickness of the metal foils 17 is not particularly limited, but is preferably 30 µm or less.

The metal foils 17 are preferably made to adhere to the collector electrodes by using the adhesive 18. The adhesive 18 may be either a conductive adhesive including the conductive particles or an insulating adhesive constituted by only a resin component, and may be either an adhesive formed in a film shape or a liquid adhesive. For the metal foils 17, it is possible to use, for example, a metal foil with an adhesive layer in which a layer of the adhesive 18 is preliminarily formed on one surface of the metal foil.

Examples of the preferable resin component of the adhesive 18 include an olefin resin and a copolymer of an α-olefin and a carboxylic acid such as an ethylene-vinyl acetate copolymer (EVA). In the adhesive 18, a resin of the same type as the sealing material 14 may also be used. The adhesive 18 may include a white pigment such as titanium oxide for the purpose of reflecting the light transmitting the photoelectric conversion part 20 so as to be again made incident on the photoelectric conversion part 20.

When an insulating adhesive is used as the adhesive 18, ,a thin film of the adhesive 18 is formed between the collector electrode and the metal foil 17 to such an extent that the electrical connection between the finger electrode 25 and the metal foil 17 is not impaired. When a conductive adhesive is used as the adhesive 18, the adhesive 18 interposed between the collector electrode and the metal foil 17 may be thicker than when the insulating adhesive is used. The adhesive 18 is extruded, for example, between the collector electrode and the metal foil 17, part of the collector electrode is brought into contact with the metal foil 17 without intermediary of the adhesive 18, and a large amount of the adhesive 18 is present between the transparent conductive layer 24 and the metal foil 17. The adhesive 18 is preferably filled between the transparent conductive layer 24 and the metal foil 17, without forming a gap, in the gaps between the finger electrodes 25.

On the metal foils 17, the wiring members 15 are fitted by using an adhesive 16. As the adhesive 16, for example, an insulating film-shaped or liquid adhesive can be used. When the wiring members 15 are fitted, the adhesive 16 is disposed between the wiring members 15 and the metal foils 17. As shown as an example in FIG. 5, a larger fraction of the adhesive 16 is extruded from between the wiring members 15 and the metal foils 17 and adheres to the sides of the wiring members 15. A thin film of the adhesive 16 is formed between the wiring members 15 and the metal foils 17 to an extent that does not impair the electrical connection between the wiring members 15 and the metal foils 17, and the metal foils 17 are partially brought into contact with the wiring members 15 without the intermediary of the adhesive 16.

According to the solar cell module 10 provided with the above-described constitution, by forming a low-resistance conductive path in the portion where the current density is high and the current gathers, by providing the metal foils 17 electrically connecting the collector electrodes and the wiring members 15 at the positions overlapping the wiring members 15, it is possible to reduce the serial resistance of the module. In the solar cell module 10, the plurality of the metal foils 17 are provided at intervals from each other on the rear surface side of the photoelectric conversion part 20, accordingly it is made possible to receive light from the rear surface side of the solar cells 11, and thus the reduction of the serial resistance can be achieved while the shadow loss is being suppressed. According to the solar cell module 10, for example, the light incident from the rear surface side of the module or the light incident from the light receiving surface side of the module and reflected by the second protection member 13, the second sealing material 14b or the like can be utilized for power generation.

By adopting a structure providing the metal foils 17 between the rear surface of the photoelectric conversion part 20 and the wiring members 15, cavities capable of being a factor causing exterior appearance faults, degradation of reliability or the like are made very unlikely to occur, and the suppression of damage to the solar cells 11 during the production of the module is facilitated.

FIG. 6 to FIG. 9 are each diagrams for illustrating another example of the embodiments. FIG. 6 to FIG. 8 are plan views respectively illustrating the metals foils 17A, 17B and 17C disposed on the collector electrodes, and each show the wiring member 15 with an imaginary line.

As shown in FIG. 6, the metal foil 17A is different from metal foil 17 in that a plurality of through holes 30 are formed in the metal foil 17A. When cavities (air bubbles) are present between the rear surface of the photoelectric conversion part 20 and the metal foils 17A, sometimes exterior appearance faults such as expansion of the second protection member 13 or detachment of the sealing material 14 are caused, as described above in the lamination step or the subsequent curing step. The thickness of the collector electrodes formed on the rear surface of the photoelectric conversion part 20 is thinner compared with the thickness of the wiring members 15, and hence large cavities are hardly generated between the rear surface of the photoelectric conversion part 20 and the metal foils 17A. The formation of the through holes 30 functioning as air vent holes allows the occurrence of the cavities to be more reliably suppressed.

In the metal foil 17A, pluralities of approximately circular through holes 30 are formed on both widthwise sides of the metal foil 17A not overlapping the wiring members 15. The pluralities of the through holes 30 are formed at approximately equal intervals in the lengthwise direction and in a zigzag pattern without being aligned in the widthwise direction of the metal foil 17A. The through holes 30 may be disposed in such a way that the through holes each have a diameter smaller than the spacing between the finger electrodes 25, and the through holes do not overlap the finger electrodes 25. For example, the shape and the disposition of the through holes 30 are not limited to the shape and the disposition shown in FIG. 6.

In the example shown in FIG. 7, a plurality of metal foils 17B are disposed in one line in the lengthwise direction of the wiring members 15. The length of the metal foils 17B in the direction along the lengthwise direction of the wiring members 15 is shorter than the length of the bus bar electrodes 26. The length of the metal foils 17B in the widthwise direction of the wiring members 15 is longer than the width W₁₅ of the wiring members 15, and the metal foils 17B protrude from both widthwise edges of the wiring members 15 toward outside the overlapping region. In this case, by decreasing the dimension of one metal foil 17B, the occurrence of the cavities is suppressed. The shape of the metal foils 17B is not limited to the approximately rectangular shape as shown in FIG. 7, and the respective metal foils 17B may also be connected to each other.

As shown in FIG. 8, in the metal foil 17C, similarly to the metal foil 17A, a plurality of through holes 31 functioning as air vent holes are formed. The plurality of the through holes 31 are arranged respectively in the widthwise direction and in the lengthwise direction of the metal foil 17C, and are formed in approximately rectangular shapes. The metal foil 17C has the width and the length similar to the width and the length of the metal foil 17A, but a plurality of recesses 32 are formed at the edges of the metal foil 17C and the metal foil 17C is wholly formed in a lattice form.

FIG. 9 is a diagram illustrating the formation pattern of the collector electrodes of the solar cell 11D with metal foils. In FIG. 9, the metal foil 17 is shown by an imaginary line, and the wiring member 15 is omitted. Here, the extending direction of the finger electrodes 25D is taken as the X-direction. In the case of the solar cell 11D, it is also preferable to fit a wiring member 15 to the widthwise center of the metal foil 17.

As shown in FIG. 9, in the solar cell 11D, similarly to the solar cell 11, finger electrodes 25D, which are the collector electrodes, are formed respectively in a first region Z1 covered with the metal foil 17 of the rear surface of the photoelectric conversion part 20 and a second region Z2 other than the first region Z1. However, in the solar cell 11D, the ratio (a1/A1) of the total area (a1) of the collector electrodes formed in the first region Z1 to the total area (A1) of the first region Z1 is smaller than the ratio (a2/A2) of the total area (a2) of the collector electrodes formed in the second region Z2 to the total area (A2) of the second region Z2. The solar cell 11D is different from the solar cell 11 in that the solar cell 11D has no bus bar electrodes 26.

In the example shown in FIG. 9, some of the finger electrodes 25D are formed continuously so as to widthwise cross the first region Z1, from the second region Z2 on the one side in the X-direction to the second region Z2 on the other side in the X-direction, and the rest of the finger electrodes 25D are divided into the finger electrodes 25d1 and the finger electrodes 25d2. The finger electrodes 25d1 and 25d2 are formed, for example, on the same straight lines. In other words, some of the finger electrodes 25D are continuously formed on the transparent conductive layer 24 from one end in the X-direction to the other end in the X-direction, while the rest of the finger electrodes 25D are each divided in the first region Z1.

If all the finger electrodes 25D are continuously formed from the one edge in the X-direction to the other edge in the X-direction on the transparent conductive layer 24, when the finger electrodes 25D contract in the production process or the like, the solar cell 11D tends to warp toward the rear surface side having a larger electrode area. The structure allowing at least some of the finger electrodes 25D to be divided in the first region Z1 allows such warping to be suppressed. As described below, the material cost can also be reduced.

The finger electrodes 25d1 are formed over from the second region Z2 on one side in the X-direction to one widthwise edge of the first region Z1, and the finger electrodes 25d2 are formed over from the second region Z2 on the other side in the X-direction to the other widthwise edge of the first region Z1. Pluralities of the lengthwise ends of the finger electrodes 25d1 and 25d2 are connected to both widthwise edges of the metal foil 17. In other words, the metal foil 17 is provided in a state of overlapping the lengthwise ends of the finger electrodes 25d1 and 25d2. The carriers collected by the finger electrodes 25d1 and 25d2 move from both widthwise edges of the metal foil 17, through the intermediary of the metal foil 17, to the wiring members 15.

The width and the thickness of the finger electrodes 25D are approximately the same in all the finger electrodes inclusive of the finger electrodes 25d1 and 25d2. In the solar cell 11D, the area density of the collector electrodes in the first region Z1 is smaller than the area density of the collector electrodes in the second region Z2. The area density of the collector electrodes means the total weight of the collector electrodes formed in the object region (such as the first region Z1) per the total area of the object region. The metal foil 17 is high in conductivity, and hence when the area density of the collector electrodes in the first region Z1 is reduced, or for example, the area ratio (a1/A1) is reduced, the serial resistance of the module can be reduced. When the area density of the collector electrodes in the first region Z1 is reduced, the amount of the conductive paste used is reduced, and the material cost can be reduced.

The finger electrodes 25D extending from the second region Z2 on one side in the X-direction are formed so that only 1 in 2 of the finger electrodes 25 D cross the first region Z1 widthwise. Such a proportion is not particularly limited, but is preferably approximately 1/4 to 9/10. In the part of the finger electrodes 25, in the proximity of the wiring members 15, a large amount of the carriers gather, and hence when the area density of the collector electrodes is made too small, sometimes the reduction effect of the serial resistance is not sufficiently obtained.

At least some of the collector electrodes formed in the first region Z1 may be made thinner than the collector electrodes formed in the second region Z2, and a reduction in the number of the collector electrodes and thinning of the collector electrodes may also be combined. In the first region Z1, a plurality of collector electrodes not connected to the collector electrodes extending from the second region Z2 may also be formed. In other words, the collector electrodes may also be formed in island-like shapes. The collector electrodes formed in island-like shapes are preferably fine-wire shaped electrodes in the X-direction, similarly to the finger electrodes 25D. In these cases, by reducing the area density of the collector electrodes in the first region Z1, it is also possible to reduce the material cost while the reduction of the serial resistance is being achieved.

### REFERENCE SIGNS LIST

10 solar cell module, 11,11D solar cell, 12 first protection member, 13 second protection member, 14 sealing material, 14a first sealing material, 14b second sealing material, 15 wiring member, 16,18 adhesive, 17,17A,17B,17C metal foil, 20 photoelectric conversion part, 20a semiconductor substrate, 20b,20c amorphous semiconductor layer, 21,24 transparent conductive layer, 22,25,25D,25d1,25d2 finger electrode, 26 bus bar electrode, 30,31 through hole, 32 recess, Z1 first region, Z2 second region

## Claims

1. A solar cell module comprising:
a first protection member being disposed on a light receiving surface side of the solar cell module and having transparency;
a second protection member disposed on a rear surface side of the solar cell module; and
a string provided between the first protection member and the second protection member,
wherein the string comprises:
a plurality of solar cells each having a plurality of finger electrodes formed on a rear surface of a photoelectric conversion part so as to be approximately parallel to each other;
a plurality of wiring members fitted respectively to the solar cells in directions intersecting the plurality of finger electrodes and connecting adjacent solar cells to each other; and
a plurality of metal foils provided at intervals from each other on the rear surface side of the photoelectric conversion part, at positions overlapping the wiring members in directions intersecting the plurality of finger electrodes and electrically connecting the plurality of finger electrodes and the wiring members.

2. The solar cell module according to claim 1, wherein the metal foils are provided between the rear surface of the photoelectric conversion part and the wiring members.

3. The solar cell module according to claim 2, wherein the metal foils are provided in a state of being sandwiched by the plurality of the finger electrodes and the wiring members.

4. The solar cell module according to any one of claims 1 to 3, wherein a plurality of through holes are formed in the metal foils.

5. The solar cell module according to any one of claims 1 to 4, wherein a length of the metal foils in the widthwise direction of the wiring members is longer than a width of the wiring members, and the metal foils are provided in a state of protruding from both widthwise edges of the wiring members.

6. The solar cell module according to any one of claims 1 to 5,
wherein the finger electrodes are formed respectively in first regions covered with the metal foil on the rear surface of the photoelectric conversion part and in second regions other than the first regions; and
area density of the finger electrodes in the first region is smaller than the area density of the finger electrodes in the second region.

7. The solar cell module according to claim 6,
wherein the metal foil is formed in a belt-like form, and is provided in a state of being approximately perpendicular to the finger electrodes; and
a plurality of lengthwise ends of the finger electrodes are connected to both widthwise edges of the metal foil.
